# EUROPEAN PATENT APPLICATION

(11) **EP 4 604 260 A1**
(43) Date of publication of application: **20.08.2025**
(21) Application number: 24207327.8
(22) Date of filing: 17.10.2024
(51) Int. Cl.: H01M 10/42, H01M 10/48, H01M 10/6554, H01M 10/658

(54) **CELL TEST APPARATUS AND METHOD OF MANUFACTURING CELL TEST APPARATUS**

(30) Priority: 03.01.2024 KR 20240000809
(71) Applicant: SAMSUNG SDI CO., LTD., Yongin-si, Gyeonggi-do 17084 (KR)
(72) Inventor: Kim, Jin, 17084 Yongin-si, Gyeonggi-do (KR); Ahn, Gijang, 17084 Yongin-si, Gyeonggi-do (KR); Park, Jongtaek, 17084 Yongin-si, Gyeonggi-do (KR); Kim, Hyunsung, 17084 Yongin-si, Gyeonggi-do (KR); Shin, Eunseon, 17084 Yongin-si, Gyeonggi-do (KR)
(74) Representative: Gulde & Partner

(57) **Abstract**

A method of manufacturing a cell test apparatus, the method comprising, determining by analyzing heat generated from a battery module including a plurality of cells, a thickness of a thermal-insulation layer of the cell test apparatus simulating the battery module and including one or more target cells therein, determining by analyzing a structure of the battery module, a thickness of an outer wall of the cell test apparatus; and determining a length of a spacer of the cell test apparatus.

## Description

### BACKGROUND

### Field

Aspects of embodiments of the disclosure relate to cell test apparatus and method of manufacturing cell test apparatus.

### Description of the Related Art

A secondary battery is a rechargeable battery that is designed to be discharged and recharged multiple times. Such secondary batteries are commonly used in various applications such as electronic devices (smart phones, laptops, tablets, etc.), electric vehicles, solar power generation, and emergency power supplies. For example, lithium-ion batteries are widely used in various electronic products and electric vehicles due to their high energy density and high charge/discharge efficiency.

The characteristics of the secondary battery, such as state of charge (SOC), power output, durability, and lifetime, significantly influence the performance and reliability of the secondary battery. Therefore, various secondary battery testing apparatuses are required to examine the characteristics of secondary batteries. In addition, high accuracy and reliability are demanded for the secondary battery testing apparatuses.

### SUMMARY

An objective of the disclosure is to provide a cell test apparatus and method of manufacturing cell test apparatus configured to solve the above-described problem.

These and other aspects and features of the present disclosure will be described in or will be apparent from the following description of embodiments of the present disclosure.

To solve the above technical problem, a method of manufacturing a cell test apparatus including one or more target cells, the method comprising, determining a thickness of a thermal-insulation layer of the cell test apparatus that simulates a battery module by analyzing heat generated from a battery module including a plurality of cells, determining a thickness of an outer wall of the cell test apparatus by analyzing a structure of the battery module; and determining a length of a spacer of the cell test apparatus.

According to some embodiments of the disclosure, the method further comprises, forming the thermal-insulation layer having the determined thickness, the spacer, and the outer wall that is disposed at an outer side of the thermal-insulation layer and has the determined thickness, wherein the thermal-insulation layer, the spacer, and the outer wall are disposed to surround the one or more target cells of the cell test apparatus.

According to some embodiments of the disclosure, determining the thickness of the thermal-insulation layer of the cell test apparatus comprises, obtaining a first temperature for the plurality of cells, obtaining a second temperature for the one or more target cells and determining the thickness of the thermal-insulation layer based on each of the first temperature and the second temperature value.

According to some embodiments of the disclosure, the second temperature ranges from 90% to 100% of the first temperature.

According to some embodiments of the disclosure, the plurality of cells comprises at least one center cell disposed in a central region of the battery module and an end cell disposed in an end region of the battery module, and the determining the thickness of the outer wall of the cell test apparatus comprises, obtaining a first stress value for the end cell, and obtaining a second stress value for the at least one center cell, wherein a target stress value of the one or more target cells is determined to be in a range from the first stress value to the second stress value, and the thickness of the outer wall is determined based on the target stress value.

According to some embodiments of the disclosure, the plurality of cells comprises at least one center cell disposed in a central region of the battery module and an end cell disposed in an end region of the battery module, and the determining the thickness of the outer wall of the cell test apparatus comprises, obtaining a first stress value for the end cell, and obtaining a second stress value for the at least one center cell, wherein a target stress value of the one or more target cells is determined to be a median between the first stress value and the second stress value, and the thickness of the outer wall is determined based on the target stress value.

According to some embodiments of the disclosure, determining the length of the spacer comprises, obtaining a distance between two adjacent cells in the battery module and determining the length of the spacer based on each of the obtained distance and the determined thickness of the thermal-insulation layer.

In an embodiment, a method of manufacturing a cell test apparatus preferably further comprises forming an insulation layer brought into contact with a first long-side wall portion of a cell, forming a first thermal-insulation layer brought into contact with the insulation layer, forming a second thermal-insulation layer brought into contact with a second long-side wall portion that is arranged to be opposite to the first long-side wall portion of the cell, forming a first outer wall disposed at an outer side of the first thermal-insulation layer, forming a second outer wall disposed at an outer side of the second thermal-insulation layer, forming a first spacer disposed on a first short-side wall portion of the cell and connecting the first outer wall and the second outer wall and forming a second spacer disposed on a second short-side wall portion that is arranged to be opposite to the first short-side wall portion of the cell and connecting the first outer wall and the second outer wall.

According to some embodiments of the disclosure, the method further comprises, analyzing thermal and structural properties of a battery module comprising a plurality of cells including the cell before the forming the first thermal-insulation layer.

According to some embodiments of the disclosure, analyzing the thermal and structural properties of the battery module comprises, obtaining a temperature of the plurality of cells of the battery module and determining a thickness for each of the first thermal-insulation layer and the second thermal-insulation layer based on the obtained temperature.

According to some embodiments of the disclosure, the battery module includes at least one center cell disposed in a central region of the battery module and an end cell disposed in an end region of the battery module, and the analyzing the thermal and structural properties of the battery module comprises, obtaining a first stress value for the end cell and obtaining a second stress value for the at least one center cell and determining a thickness of each of the first outer wall and the second outer wall based on the first stress value and the second stress value.

According to some embodiments of the disclosure, analyzing the thermal and structural properties of the battery module comprises, obtaining a distance between two adjacent cells in the battery module and determining a length of each of the first spacer and the second spacer, the thickness of the first thermal-insulation layer, and the thickness of the second thermal-insulation layer based on the obtained distance.

According to some embodiments of the disclosure, the method further comprises forming an insulation layer disposed between the first long-side wall portion and the first thermal-insulation layer.

According to some embodiments of the disclosure, the method further comprises forming a cooling unit disposed at a lower portion of the cell test apparatus.

According to some embodiments of the disclosure, a cooling temperature of the cooling unit is the same as a cooling temperature of a cooling unit of a battery module, and the battery module comprises a plurality of cells including the cell.

Another aspect of the disclosure relates to a cell test apparatus, which comprises a first thermal-insulation layer disposed on a first long-side wall portion of a cell, an insulation layer disposed between the first long-side wall portion and the first thermal-insulation layer of the cell, a second thermal-insulation layer brought into contact with a second long-side wall portion that is arranged to be opposite to the first long-side wall portion of the cell, a first outer wall disposed at an outer side of the first thermal-insulation layer, a second outer wall disposed at an outer side of the second thermal-insulation layer, a first spacer disposed on a first short-side wall portion of the cell and connecting the first outer wall and the second outer wall; and a second spacer disposed on a second short-side wall portion that is arranged to be opposite to the first short-side wall portion of the cell and connecting the first outer wall and the second outer wall; and a cooling unit disposed at a lower portion of the cell.

According to some embodiments of the disclosure, each of the first thermal-insulation layer and the second thermal-insulation layer comprises bakelite, and each of the first thermal-insulation layer and the second thermal-insulation layer has a thickness in a range of 10 mm to 30 mm.

According to some embodiments of the disclosure, each of the first outer wall and the second outer wall comprises stainless steel, and each of the first outer wall and the second outer wall has a thickness in a range of 17 mm and 35 mm.

According to some embodiments of the disclosure, a length of the first spacer is equal to a length of the second spacer, and the length of the first spacer is determined by a sum of a thickness of the cell, a thickness of the first thermal-insulation layer, a thickness of the second thermal-insulation layer, and a thickness of the insulation layer.

According to some embodiments of the disclosure, the insulation layer comprises an insulation sheet and an adhesive layer, and the adhesive layer is disposed on opposite sides of the insulation sheet.

According to embodiments of the disclosure, it is possible to manufacture a cell test apparatus having the thickness of the thermal-insulation layer that is determined by analyzing the heat generated from the battery module. As a result, the accuracy and reliability of the cell test apparatus can be improved.

According to embodiments of the disclosure, it is possible to determine the thickness of the outer wall of the cell test apparatus by analyzing the structure of the battery module. As a result, the accuracy and reliability of the cell test apparatus can be improved.

According to embodiments of the disclosure, by analyzing the thermal and structural properties of the battery module, it is possible to provide a method of manufacturing the cell test apparatus with improved accuracy and reliability.

However, aspects and features of the present disclosure are not limited to those described above, and other aspects and features not mentioned will be clearly understood by a person skilled in the art from the detailed description, described below.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a perspective view of a cell test apparatus according to embodiments of the disclosure.
FIG. 2 is an exemplary perspective view of a target cell used in the cell test apparatus according to embodiments of the disclosure.
FIG. 3 is an exemplary diagram of a module simulated by a cell test apparatus according to some embodiments of the disclosure.
FIG. 4 is a graph illustrating a method of determining a thickness of a thermal-insulation layer according to some embodiments of the disclosure.
FIG. 5 is a graph illustrating a method of determining a thickness of an outer wall according to some embodiments of the disclosure.
FIGS. 6 and 7 are diagrams for illustrating a cell test apparatus according to some embodiments of the disclosure.
FIG. 8 is a flowchart illustrating the method of manufacturing the cell test apparatus according to some embodiments of the disclosure.
FIG. 9 is a flowchart illustrating a method of determining the dimensions for the components of the cell test apparatus according to some embodiments of the disclosure.
FIG. 10 is a flowchart illustrating a method of determining the thickness of the thermal-insulation layer according to some embodiments of the disclosure.
FIG. 11 is a flowchart illustrating the method of determining the thickness of the outer wall according to some embodiments of the disclosure.
FIG. 12 is a flowchart illustrating the method of manufacturing the cell test apparatus according to some embodiments of the disclosure.
FIGS. 13 to 16 are diagrams for explaining a cell test apparatus according to some embodiments of the disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Throughout the specification, reference signs with four digits, such as 1000 or 1300, refer to embodiments of the method and method steps. Reference signs with two or three digits, such as 20 or 100, refer to embodiments or features of the cell test apparatus.

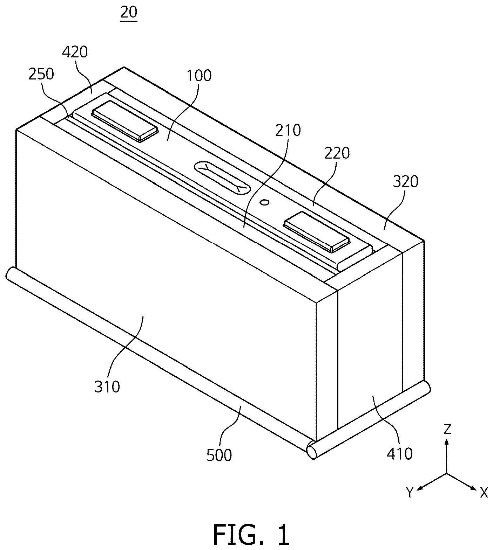

FIG. 1 is a perspective view of a cell test apparatus according to embodiments of the disclosure. Referring to FIG. 1, a cell test apparatus 20 is provided to test characteristics such as lifetime, state of charge (SOC), power output, durability, and reliability of a target cell 100. For example, the cell test apparatus 20 may measure capacity retention of the target cell 100 after repeated charge-discharge cycles within a chamber. The capacity retention may be the ratio of discharge capacity to initial discharge capacity after the charge-discharge cycles.

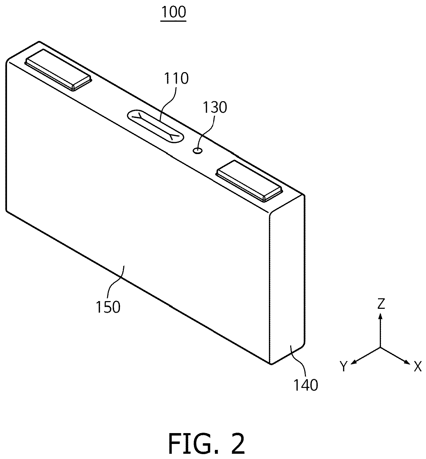

FIG. 2 is a perspective view of a target cell used in the cell test apparatus according to embodiments of the disclosure. Referring to FIG. 2, the target cell 100 may include an electrode assembly, a vent portion 110, an electrolyte injection hole 130, a first terminal, a second terminal, a short-side wall portion 140, and a long-side wall portion 150.

The electrode assembly may be formed by winding or stacking a stack of a first electrode plate, a separator, and a second electrode plate, which can be formed as thin plates or films. When the electrode assembly is a wound stack, a winding axis may be parallel to the longitudinal direction of a case. In other embodiments, the electrode assembly may be a stack type rather than a wound type, and the shape of the electrode assembly is not limited in the disclosure. In addition, the electrode assembly may be a Z-stack electrode assembly in which a positive electrode plate and a negative electrode plate are inserted into both sides of a separator, which is then bent into a Z-stack. The first electrode plate of the electrode assembly may serve as a negative electrode, and the second electrode plate may serve as a positive electrode. Alternatively, the second electrode plate of the electrode assembly may serve as a negative electrode, and the first electrode plate may serve as a positive electrode.

A first electrode tab of the first electrode plate and a second electrode tab of the second electrode plate may be respectively positioned at both ends (e.g., opposite ends) of the electrode assembly. In some embodiments, the electrode assembly may be accommodated in the case along with an electrolyte. In addition, in the electrode assembly, a first current collector and a second current collector may be welded and connected to the first electrode tab of the first electrode plate and the second electrode tab of the second electrode plate exposed on both sides of the electrode assembly, respectively, to then be positioned thereat, respectively.

The vent portion 110 may be located at an upper portion of the target cell 100. The vent portion 110 may reduce or prevent an explosion of the secondary cell or a chain exothermic reaction of other secondary cells arranged around the secondary cell. The electrolyte injection hole 130 may be formed on an upper surface of a case of the target cell 100. Electrolyte may be injected into the case through the electrolyte injection hole 130.

A first direction X may refer to an X-axis direction. A second direction Y may be perpendicular to the first direction X. The second direction Y may refer to a Y-axis direction. A third direction Z may be perpendicular to each of the first direction X and the second direction Y. The third direction Z may refer to a Z-axis direction.

The long-side wall portion 150 may include a first long-side wall portion and a second long-side wall portion. The first long-side wall portion and the second long-side wall portion may be opposite to each other. The first long-side wall portion and the second long-side wall portion may be opposite to each other while being spaced apart from each other in the second direction Y.

The short-side wall portion 140 may include a first short-side wall portion and a second short-side wall portion. The first short-side wall portion and the second short-side wall portion may be opposite to each other. The first short-side wall portion and the second short-side wall portion may be opposite to each other while being space apart from each other in in the first direction X. The area of each of the first short-side wall portion and the second short-side wall portion may be smaller than the area of each of the first long-side wall portion and the second long-side wall portion.

FIG. 2 illustrates that the target cell 100 can have the shape of a prismatic secondary battery; however, other shapes of the target cell 100 are within the scope of the disclosure. For example, instead of the prismatic secondary battery, the target cell 100 may be a cylindrical secondary battery, a coin-type secondary battery, or a side-terminal secondary battery.

Referring back to FIG. 1, the cell test apparatus 20 may include a first thermal-insulation layer 210, a second thermal-insulation layer 220, an insulation layer 250, a first outer wall 310, a second outer wall 320, a first spacer 410, a second spacer 420, and a cooling unit 500.

The insulation layer 250 may be disposed on the first long-side wall portion of the target cell 100. The insulation layer 250 may be in contact with the first long-side wall portion. The insulation layer 250 may include an insulating material.

In some embodiments, the insulation layer 250 may be disposed on each of the first long-side wall portion and the second-long side wall portion of the target cell 100. The insulation layer 250 may be disposed between the first long-side wall portion and the first thermal-insulation layer 210 and also between the second long-side wall portion and the second thermal-insulation layer 220.

The first thermal-insulation layer 210 may be disposed on the first long-side wall portion of the target cell 100. The first thermal-insulation layer 210 may cover the first long-side wall portion. For example, the first thermal-insulation layer 210 may cover a portion of the first long-side wall portion or may completely cover the first long-side wall portion. The insulation layer 250 may be disposed between the first long-side wall portion and the first thermal-insulation layer 210.

The second thermal-insulation layer 220 may be disposed on the second long-side wall portion of the target cell 100. The second thermal-insulation layer 220 may be in contact with the second long-side wall portion. The second thermal-insulation layer 220 may cover the second long-side wall portion. For example, the second thermal-insulation layer 220 may cover a portion of the second long-side wall portion or may completely cover the second long-side wall portion.

Each of the first thermal-insulation layer 210 and the second thermal-insulation layer 220 may include a thermal-insulation material. For example, each of the first thermal-insulation layer 210 and the second thermal-insulation layer 220 may include a phenol-based synthetic resin such as Bakelite. However, the disclosure is not limited thereto. Each of the first thermal-insulation layer 210 and the second thermal-insulation layer 220 may include, for example, any thermal-insulation material and/or any combination of thermal-insulation materials.

The first outer wall 310 may be disposed on the first thermal-insulation layer 210. The first outer wall 310 may be disposed at an outer side of the first thermal-insulation layer 210. Here, the outer side of the first thermal-insulation layer 210 may be in a direction opposite to the target cell 100. The first outer wall 310 may be in contact with the first thermal-insulation layer 210. The first outer wall 310 may cover the first thermal-insulation layer 210. A length of the first outer wall 310 in the first direction X may be greater than a length of the target cell 100 in the first direction X.

The second outer wall 320 may be disposed on the second thermal-insulation layer 220. The second outer wall 320 may be disposed at an outer side of the second thermal-insulation layer 220. Here, the outer side of the second thermal-insulation layer 220 may be in a direction opposite to the target cell 100. The second outer wall 320 may be in contact with the second thermal-insulation layer 220. The second outer wall 320 may cover the second thermal-insulation layer 220. A length of the second outer wall 320 in the first direction X may be greater than a length of the target cell 100 in the first direction X.

Each of the first outer wall 310 and the second outer wall 320 may be formed as a plate. The target cell 100 may expand during a charge/discharge test due to swelling or the like. For example, the target cell 100 may expand in the second direction Y. In this case, each of the first outer wall 310 and the second outer wall 320 may exert pressure on the target cell 100 in response to the expansion of the target cell 100.

Each of the first outer wall 310 and the second outer wall 320 may include, for example, aluminum and stainless steel. However, the disclosure is not limited thereto.

The first spacer 410 may be disposed on the first short-side wall portion of the target cell 100. The first spacer 410 may cover the first short-side wall portion. The first spacer 410 may be disposed between the first outer wall 310 and the second outer wall 320. The first spacer 410 may connect the first outer wall 310 and the second outer wall 320. The first spacer 410 may be fixed to each of the first outer wall 310 and the second outer wall 320.

The second spacer 420 may be disposed on the second short-side wall portion of the target cell 100. The second spacer 420 may cover the second short-side wall portion. The second spacer 420 may be disposed between the first outer wall 310 and the second outer wall 320. The second spacer 420 may connect the first outer wall 310 and the second outer wall 320. The second spacer 420 may be fixed to each of the first outer wall 310 and the second outer wall 320.

The target cell 100 may be surrounded by the first outer wall 310, the second outer wall 320, the first spacer 410, and the second spacer 420.

The cooling unit 500 may be disposed at a lower portion of the target cell 100. The cooling unit 500 may control a temperature of the target cell 100 by circulating coolant. In some embodiments, a temperature of the coolant in the cooling unit 500 may be maintained constant.

While it is illustrated that a single target cell 100 is disposed within the cell test apparatus 20, the disclosure is not limited thereto. For example, two or more target cells 100 may be disposed within the cell test apparatus 20. In this case, two or more target cells 100 may be disposed between the first thermal-insulation layer 210 and the second thermal-insulation layer 220.

In some embodiments, the cell test apparatus 20 may further include a controller (not shown). The controller may control a testing operation of the cell test apparatus 20. The controller may obtain data about characteristics of the target cell 100.

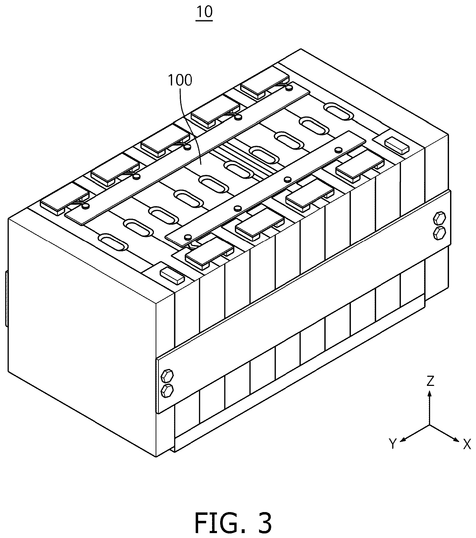

FIG. 3 is an exemplary diagram of a module simulated by a cell test apparatus according to some embodiments of the disclosure.

A cell test apparatus (e.g., the cell test apparatus 20 shown in FIG. 1) according to some embodiments of the disclosure may be manufactured by simulating a battery module 10 that includes at least one target cell 100. The battery module 10 may include a plurality of cells with at least one of the plurality of cells being identical to the target cell 100. That is, at least one cell among the plurality of cells included in the battery module 10 may be identical to the target cell being tested by the cell test apparatus 20.

The battery module 10 may include electrodes, a plurality of target cells 100 arranged in the second direction Y, connection tabs connecting adjacent target cells 100, and a protection circuit module having one end connected to the connection tabs. The protection circuit module may be a battery management system (BMS). Further, each of the connection tabs may include a body portion that contacts the electrodes between adjacent target cells and an extension portion extending from the body portion and connecting to the protection circuit module. The connection tabs may be for example, bus bars.

The battery module 10 shown in FIG. 3 is an example. For example, the battery module 10 may include more or fewer cells than those shown in FIG. 3. Further, the battery module 10 may be further arranged in one or more rows with one or more cells in the first direction X. Further, the battery module 10 may be part of a battery pack in which one or more battery modules are combined. Hereinafter, a method of manufacturing a cell test apparatus that simulates the battery module is described in detail.

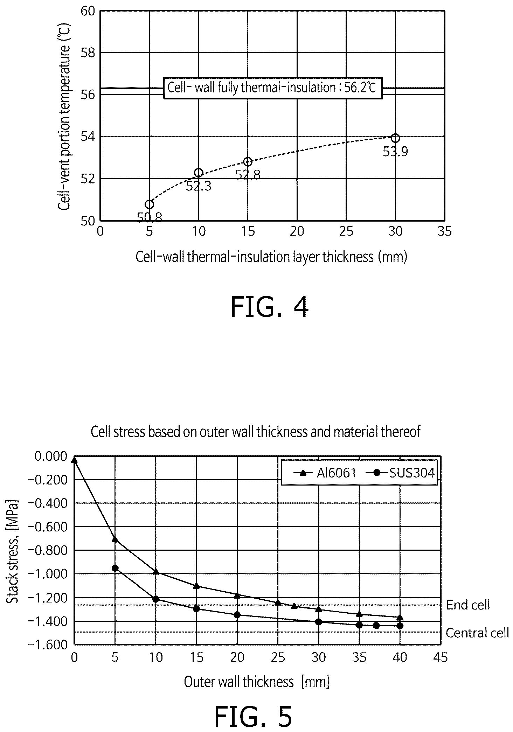

FIG. 4 is a graph illustrating a method of determining a thickness of a thermal-insulation layer according to some embodiments of the disclosure.

Referring to FIG. 4, a method of manufacturing a cell test apparatus according to some embodiments may analyze heat generated by a battery module to determine a thickness of a thermal-insulation layer of the cell test.

For example, a first temperature for a plurality of cells included in the battery module may be obtained. The first temperature may be obtained by measuring temperatures of the vent portions of the plurality of cells during a certain number of cycles of a charge/discharge test of the battery module. For example, the first temperature may be obtained by measuring the temperatures of the vent portions by means of a temperature sensor providing a first temperature output signal. For example, the first temperature may be obtained by measuring the temperatures of the vent portions of the respective cells after 50 cycles of the charge/discharge test of the battery module.

In some embodiments, the first temperature may be the same or approximately a temperature value obtained under full thermal-insulation conditions for each cell of the battery module.

Subsequently, the cell test apparatus may obtain a second temperature of the target cell, e.g. by means of a temperature sensor providing a second temperature output signal. The second temperature may be obtained by measuring a temperature of a vent portion of the target cell during a certain number of cycles of a charge/discharge test of the target cell in the cell test apparatus, e.g. by means of a temperature sensor providing a second temperature output signal. The number of charge and discharge cycles for the test of the target cell is the same as the number of charge and discharge cycles for the test of the battery module.

Then, based on each of the first temperature and the second temperature (or the first and second temperature output signal), a thickness of a thermal-insulation layer of the cell test apparatus may be determined, e.g. by a computer configured to determine a thickness of a thermal-insulation layer of the cell test apparatus based on the first and second temperature output signal. The second temperature may be measured while varying the thickness of the thermal-insulation layer such that the second temperature falls within a range related to the first temperature such as, for example, a range of from 90% to 100% (of the numerical value) of the first temperature. 100% of the first temperature means identical temperature. The second temperature may deviate from the first temperature by ±10% or less of the numerical value of the first temperature. For instance, the second temperature may deviate from the first temperature by ±10.0 °C or less, preferably ±6.0 °C or less, most preferred ±5.6 °C or less.

For example, as shown in FIG. 4, after 50 charge/discharge cycles for the battery module, the first temperature of 56.2 °C was measured. Thereafter, the thickness of the thermal-insulation layer of the cell test apparatus was varied to 5 mm, 10 mm, 15 mm, and 30 mm, and the second temperature for each target cell was measured. The results showed that the second temperature was 50.6 °C when the thickness of the thermal-insulation layer was 5 mm, the second temperature was 52.3 °C when the thickness of the thermal-insulation layer was 10 mm, the second temperature was 52.8 °C when the thickness of the thermal-insulation layer was 15 mm, and the second temperature was 53.9 °C when the thickness of the thermal-insulation layer was 30 mm. The thickness of the thermal-insulation layer that allows the second temperature to fall in the range of 90% to 100% (of the numerical value) of the first temperature may be about 10 mm or more. Through this analysis, a correlation can be observed that as the thickness of the thermal-insulation layer increases, the second temperature approaches the first temperature.

FIG. 5 is a graph illustrating a method of determining a thickness of an outer wall according to some embodiments of the disclosure.

Referring to FIG. 5, in the method of manufacturing the cell test apparatus according to some embodiments, the structure of the battery module may be analyzed to determine the thickness of the outer wall of the cell test apparatus.

The battery module may include a plurality of cells. The battery module may include one or more center cells disposed in a central region and an end cell disposed in an end region. For example, the number of the one or more center cells may be one or two. For example, in a case where the battery module includes an even number of cells arranged in one direction, the one or more center cells may consist of two cells disposed at the center. In contrast, in a case where the battery module includes an odd number of cells arranged in one direction, the one or more center cells may consist of a single cell disposed at the center. The end cell may be a cell disposed at each of the opposite ends of the battery module.

In the charge/discharge test of the battery module, a first stress value experienced by the end cell may be obtained, and a second stress value experienced by the one or more center cells may be obtained. First and second stress values may be measured by pressure sensors providing a first and second pressure output signal. Based on each of the first stress value and the second stress value, a target stress value may be determined. Subsequently, a stress value applied to the target cell may be measured as the thickness of the outer wall of the cell test apparatus is varied. Based on the measured stress value and a target stress value, the thickness of the outer wall may be determined, e.g. by a computer configured to calculate the thickness of the outer wall based on the target stress value and the measured stress value (e.g. first and second pressure output signal) provided by the corresponding means, e.g. pressure sensors.

In some embodiments, the target stress value may fall within a certain range. For example, the target stress value may be in a range from the first stress value to the second stress value.

In some embodiments, the target stress value may be a median between the first stress value and the second stress value. The stack stress may be the stress value (e.g. compressive stress) that the battery cell receives from adjacent structures. The stack stress can be measured by a pressure sensor.

The graph shown in FIG. 5 shows the stress value (stack stress) of the center cell and the stress value (stack stress) of the end cell of the battery module, and the stress value (stack stress) applied to the cell as a function of the thickness of the outer wall of the cell test apparatus. As a result of analyzing the structure of the battery module, it was determined that the first stress value of the end cell was -1.3 MPa (megapascal) and the second stress value of the center cell was -1.5 MPa.

For example, in a case where the target stress value ranges from the first stress value to the second stress value, the target stress value may range from -1.3 MPa to -1.5 MPa. In a case where the outer wall is formed of aluminum (Al) (e.g., AI6061), the thickness of the outer wall may be 25 mm or more. In a case where the outer wall is formed of stainless steel (e.g., SUS304), the thickness of the outer wall may be 12 mm or more. For example, in the case where the outer wall is formed of stainless steel, the outer wall may have a thickness ranging from 17 mm to 35 mm.

In another example, in a case where the target stress value is a median between the first stress value and the second stress value, the target stress value may be -1.4 MPa. In this case, in a case where the outer wall is formed of stainless steel, the outer wall may have a thickness of 28 mm.

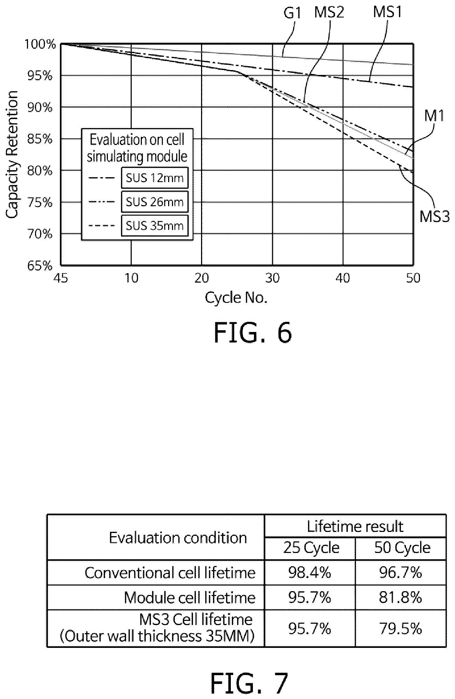

FIGS. 6 and 7 are diagrams for illustrating a cell test apparatus according to some embodiments of the disclosure.

FIG. 6 illustrates graphs showing cell lifetime evaluation data from a conventional cell test apparatus, cell lifetime evaluation data from a module test apparatus, and cell lifetime evaluation data from a cell test apparatus that simulates a battery module that are obtained by measuring capacity retention on the same cell over charge/discharge cycles. FIG. 7 is a table summarizing some of the results of FIG. 6. Hereinafter, lifetime may refer to the capacity retention.

Referring to FIG. 6, a first graph G1 is a graph showing a result of a cell lifetime test using the conventional cell test apparatus. A second graph M1 is a graph showing a result of a cell lifetime test using the module test apparatus.

In a case where the number of charge/discharge cycles exceeds 20, the gap between the first graph G1 and the second graph M1 gradually increases. In other words, for the same cell, there is a difference between the lifetime result obtained from the conventional test apparatus and the lifetime result obtained from the module test apparatus.

Third to fifth graphs MS1, MS2, and MS3 are graphs showing the results of cell lifetime tests conducted by using the cell test apparatus that is manufactured by the manufacturing methods according to some embodiments of the disclosure. In all of the third to fifth graphs MS1, MS2, and MS3, a 10 mm-thick Bakelite insulation layer was used, and the outer wall was made of SUS304 stainless steel. In the third graph MS1, the thickness of the outer wall is 12mm. In the fourth graph MS2, the thickness of the outer wall is 26mm. In the fifth graph MS3, the thickness of the outer wall is 35 mm.

Referring to FIG. 6, the third graph MS1 is similar to the first graph G1. In contrast, the fourth graph MS2 and the fifth graph MS3 are similar to the second graph M1. Between the fourth graph MS2 and the fifth graph MS3, the fourth graph MS2 is the most similar to the second graph M1. That is, in response to a case where the thickness of the outer wall of the cell test apparatus is 26 mm or 35 mm, the lifetime test result of the cell test apparatus is similar to the lifetime test result of the module test apparatus.

FIG. 7 is the table summarizing the cell lifetime evaluation data from the conventional cell test apparatus, the cell lifetime evaluation data from the module test apparatus, and the cell lifetime evaluation data from the cell test apparatus simulating the battery module. The cell lifetime evaluation data from the cell test apparatus that simulates the battery module may be indicated by the fifth graph MS3 of FIG. 6.

Comparing the results after 25 charge/discharge cycles, the cell lifetime tested with the conventional cell test apparatus is 98.4%, while the cell lifetime tested with the module test apparatus is 95.7%, which shows a slight difference. However, after 50 charge/discharge cycles, the cell lifetime tested with the conventional cell test apparatus is 96.7%, while the cell lifetime tested with the module test apparatus is 81.8%. This indicates that the difference between the two lifetime values is increased. In other words, when the module is manufactured only based on the lifetime evaluation results from the conventional cell test apparatus, the module may not be reliable. Therefore, there is a need for a method to improve the accuracy and reliability of the cell test apparatus.

Comparing the results after 25 charge/discharge cycles, the cell lifetime tested with the cell test apparatus simulating the module that has the outer wall thickness of 35 mm (hereinafter, referred to as a MS3 cell lifetime) is 95.7%%, and the cell lifetime tested with the module test apparatus (hereinafter, referred to as a module cell lifetime) is 95.7%, which is the same as that of the cell test apparatus simulating the module. After 50 charge/discharge cycles, the MS3 cell lifetime is 79.5% and the module cell lifetime is 81.8%, indicating that the two lifetime values are similar. Thus, compared to the conventional cell test apparatus, it can be confirmed that the cell test apparatus according to some embodiments of the disclosure can provide results similar to the results of the module test apparatus. Based on these experimental results, it can be concluded that the cell test apparatus manufactured by the method of manufacturing the cell test apparatus of the disclosure exhibits improved accuracy and reliability in test results compared to the conventional cell test apparatus.

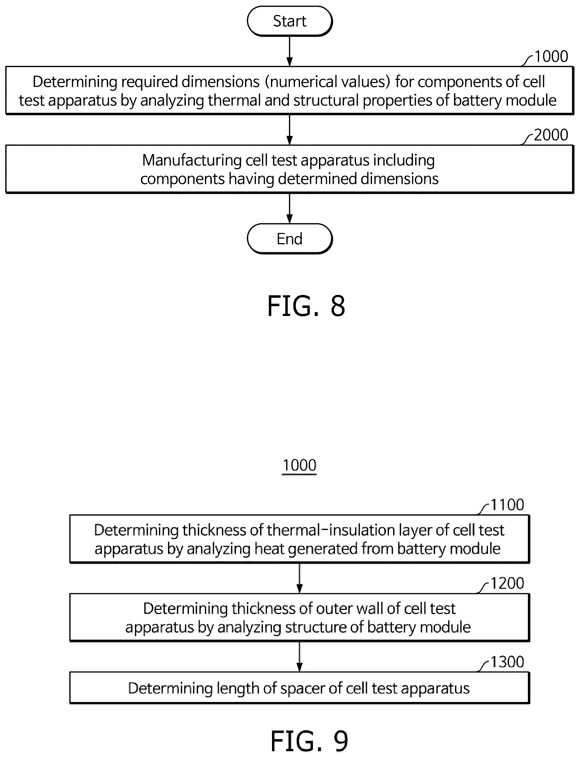

FIG. 8 is a flowchart illustrating the method of manufacturing the cell test apparatus according to some embodiments of the disclosure.

Referring to FIG. 8, in the method 1000 of manufacturing the cell test apparatus, required dimensions (numerical values) for components of the cell test apparatus may be determined by analyzing thermal and structural properties of a battery module. Thereafter, the cell test apparatus including the components having the determined dimensions may be manufactured by method 2000. In other words, because the cell test apparatus is manufactured based on the dimensions for the components of the cell test apparatus that are determined by analyzing the thermal and structural properties of the battery module, the accuracy and reliability of the test results provided by the cell test apparatus may be greatly improved. Hereinafter, each step of FIG. 8 is described in detail.

FIG. 9 is a flowchart illustrating a method of determining the dimensions for the components of the cell test apparatus according to some embodiments of the disclosure.

Referring to FIG. 9, the method 1000 for determining the dimensions for the components of the cell test apparatus may begin with step 1100, that is determining a thickness of a thermal-insulation layer of the cell test apparatus by analyzing heat generated from a battery module . Next, in step 1200, a thickness of an outer wall of the cell test apparatus may be determined by analyzing a structure of the battery module. Finally, in step 1300, a length of a spacer of the cell test apparatus may be determined .

In the method 1300 for determining the length of the spacer, a distance between two adjacent cells in the battery module is obtained, and the length of the spacer may be determined based on each of the obtained distance and the thickness of the thermal-insulation layer. For example, the length of the spacer may be determined as the sum of the distance between two adjacent cells, the thickness of the thermal-insulation layer, and a thickness of a target cell.

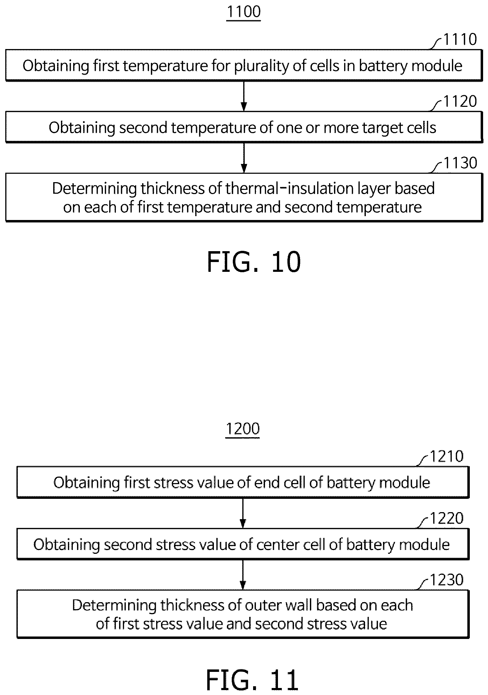

FIG. 10 is a flowchart illustrating a method of determining the thickness of the thermal-insulation layer according to some embodiments of the disclosure.

Referring to FIG. 10, the method 1100 for determining the thickness of the thermal-insulation layer of the cell test apparatus may begin with step 1110, that is obtaining a first temperature for a plurality of cells in the battery module , e.g. by means of a temperature sensor providing a first temperature output signal. The first temperature may be obtained by measuring temperatures of vent portions of the plurality of cells during a charge/discharge test of the battery module. Next, a second temperature for one or more target cells may be obtained in step 1120, e.g. by means of a temperature sensor providing a second temperature output signal. The second temperature for the one or more target cells may be obtained by measuring temperatures of vent portions of the one or more target cells during a charge/discharge test of the one or more target cells. Subsequently, based on each of the first temperature and the second temperature (or the respective first and second temperature output signals), the thickness of the thermal-insulation layer of the cell test apparatus may be determined in step 1130, e.g. by a computer configured to determine a thickness of a thermal-insulation layer of the cell test apparatus based on the first and second temperature output signal. For example, the thickness of the thermal-insulation layer may be determined such that the second temperature value is within a range related to the first temperature.

FIG. 11 is a flowchart illustrating the method of determining the thickness of the outer wall according to some embodiments of the disclosure.

Referring to FIG. 11, the method 1200 for determining the thickness of the outer wall of the cell test apparatus may begin with step 1210, that is obtaining a first stress value of an end cell of the battery module . The battery module may include a center cell disposed in a central region and an end cell disposed in an end region. Next, a second stress value of the center cell of the battery module may be obtained in step 1220. Subsequently, based on each of the first stress value and the second stress value, the thickness of the outer wall of the cell test apparatus may be determined in step 1230. In one example, a target stress value for one or more target cells of the cell test apparatus is determined to be in a range from the first stress value to the second stress value, and the thickness of the outer wall is determined based on the target stress value. In another example, a target stress value for one or more target cells of the cell test apparatus is determined to be a median between the first stress value and the second stress value, and the thickness of the outer wall is determined based on the target stress value.

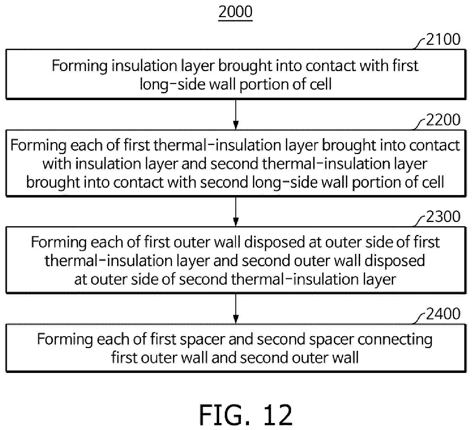

FIG. 12 is a flowchart illustrating the method of manufacturing the cell test apparatus according to some embodiments of the disclosure.

Referring to FIG. 12, the method 2000 for manufacturing the cell test apparatus including components having determined dimensions (numerical values) may begin wit step 2100, with forming an insulation layer brought into contact with a first long-side wall portion of a cell . Next, each of a first thermal-insulation layer brought into contact with the insulation layer and a second thermal-insulation layer brought into contact with a second long-side wall portion of the cell may be formed in step 2200. Thereafter, each of a first outer wall disposed at an outer side of the first thermal-insulation layer and a second outer wall disposed at an outer side of the second thermal-insulation layer may be formed in step 2300. Each of a first spacer and a second spacer connecting the first outer wall and the second outer wall may be formed in step 2400.

In some embodiments, a cooling unit is disposed at a lower portion of the cell. A cooling temperature of the cooling unit may be identical to or approximately equal to a cooling temperature of a cooling unit used in the battery module.

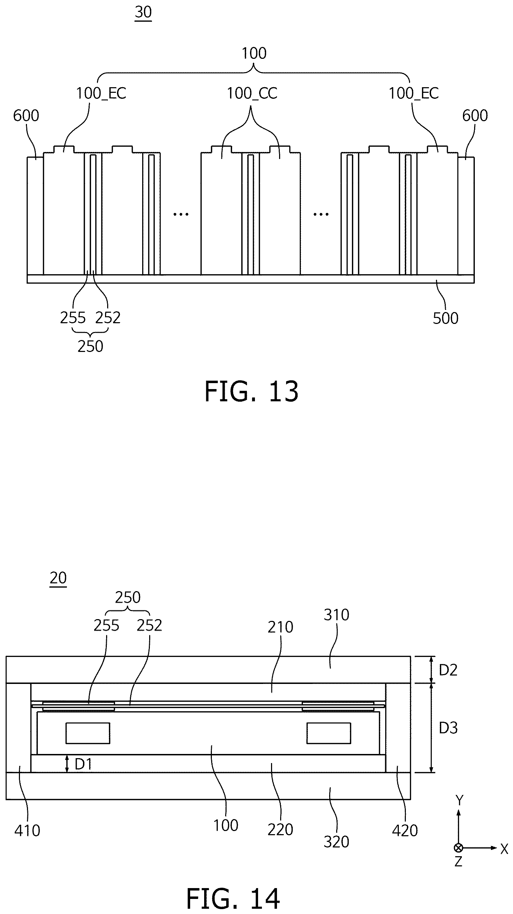

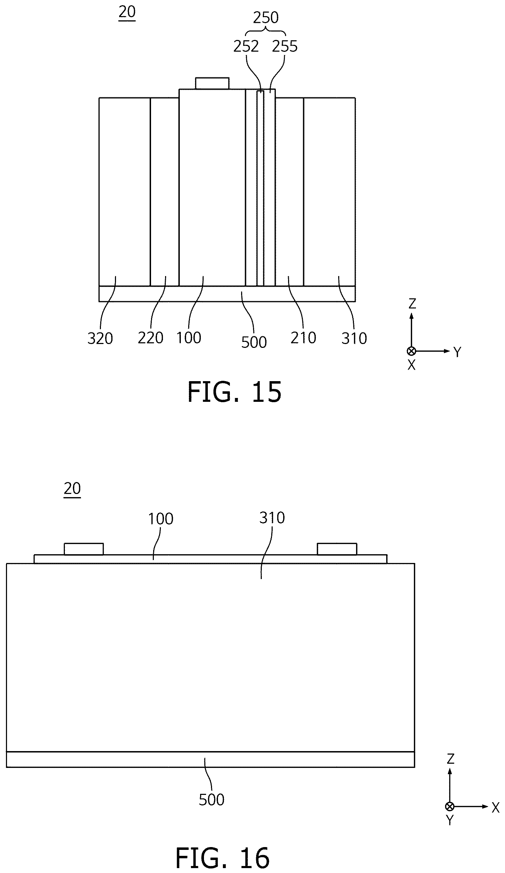

FIGS. 13 to 16 are diagrams for explaining a cell test apparatus according to some embodiments of the disclosure. FIG. 13 is an exemplary diagram of a battery module including a target cell.

Referring to FIG. 13, a battery module 30 may include a plurality of cells 100, an insulation layer 250 disposed between the cells, and end plates 600 disposed at opposite ends of a group of the plurality of cells 100.

The number of the cells 100 in the battery module 30 may be 16. For example, the battery module 30 may include 16 cells 100 that are arranged in one direction. The battery module 30 may include a central cell 100_CC in a center region and an end cell 100_EC in an end region.

A distance between two adjacent cells 100 within the battery module 30 may be 1.16 mm. The distance between two adjacent cells 100 may be equal to a thickness of the insulation layer 250. The insulation layer 250 may include an insulation sheet 252 and an adhesive layer 255. The adhesive layer 255 may be disposed on both sides (opposite sides) of the insulation sheet 252. The insulation layer 250 may adhere adjacent target cells 100 by the adhesive layer 255.

Referring now to FIGS. 14 to 16, the cell test apparatus 20 is described.

The cell test apparatus 20 may be manufactured by using the method of manufacturing the cell test apparatus described in FIGS. 8 to 12 and simulating the battery module 30 of FIG. 13. The description of the configurations of the cell test apparatus 20 may be the same as that described in FIGS. 1 and 2. For the sake of convenience of explanation, the description focuses on differences from the configurations described in FIGS. 1 and 2.

Each of the first thermal-insulation layer 210 and the second thermal-insulation layer 220 may have a first thickness D1. The first thickness D1 may be in a range from 10 mm to 30 mm. For example, the first thickness D1 may be 10 mm.

The insulation layer 250 may have a thickness of 1.16 mm. The insulation layer 250 may include the insulation sheet 252 and the adhesive layer 255. The structure of the insulation layer 250 may be the same as the insulation layer 250 shown in FIG. 13.

Each of the first outer wall 310 and the second outer wall 320 may have a second thickness D2. Each of the first outer wall 310 and the second outer wall 320 may include stainless steel. The second thickness D2 may be in a range from 17 mm to 35 mm. For example, the second thickness D2 may be 27 mm.

Each of the first spacer 410 and the second spacer 420 may have a third length D3. The third length D3 may be the sum of a thickness of the target cell 100 in the second direction Y, a thickness of the first thermal-insulation layer, a thickness of the second thermal-insulation layer, a thickness of the insulation layer 250, and a thickness of the adhesive layer 255. The thickness of the target cell 100 in the second direction Y may be 32.1 mm. In a case where the second thickness D2 is 10 mm, the third length D3 may be 53.26 mm.

Although the present disclosure has been described above with respect to embodiments thereof, the present disclosure is not limited thereto. Various modifications and variations can be made thereto by those skilled in the art within the scope of the present disclosure and the equivalent scope of the appended claims.

### [DESCRIPTION OF SOME REFERENCE SYMBOLS]

| | | | |
|---|---|---|---|
| 10: | battery module | 20: | cell test apparatus |
| 100: | target cell | 210: | first thermal-insulation layer |
| 220: | second thermal-insulation layer | | |
| 310: | first outer wall | 320: | second outer wall |
| 410: | first spacer | 420: | second spacer |
| 500: | cooling unit | | |

## Claims

1. A method of manufacturing a cell test apparatus (20) including one or more target cells (100), the method comprising:
determining a thickness of a thermal-insulation layer (250) of the cell test apparatus (20), wherein the cell test apparatus (20) simulates a battery module (10) having a plurality of cells (100), by analyzing heat generated from the battery module (1100),
determining a thickness of an outer wall of the cell test apparatus (20) by analyzing a structure of the battery module (1200); and
determining a length of a spacer of the cell test apparatus (1300).

2. The method as claimed in claim 1, further comprising:
forming the thermal-insulation layer (250) having the determined thickness, the spacer, and the outer wall that is disposed at an outer side of the thermal-insulation layer (250) and has the determined thickness, wherein the thermal-insulation layer (250), the spacer, and the outer wall are disposed to surround the one or more target cells of the cell test apparatus (2000).

3. The method as claimed in claim 1 or 2, wherein determining the thickness of the thermal-insulation layer (250) of the cell test apparatus (1100) comprises:
obtaining a first temperature of the plurality of cells (1110);
obtaining a second temperature of the one or more target cells (1120); and
determining the thickness of the thermal-insulation layer (250) based on each of the first temperature and the second temperature value (1130).

4. The method as claimed in claim 3, wherein the second temperature ranges from 90% to 100% of the first temperature.

5. The method as claimed in one of the preceding claims, wherein the plurality of cells (100) comprises at least one center cell (100_CC) disposed in a central region of the battery module (30) and an end cell (100_EC) disposed in an end region of the battery module (30), and
the determining the thickness of the outer wall of the cell test apparatus (1200) comprises:
obtaining a first stress value of the end cell (1210), and
obtaining a second stress value of the at least one center cell (1220),
wherein a target stress value of the one or more target cells (100) ranges from the first stress value to the second stress value (1230), and the thickness of the outer wall is determined based on the target stress value.

6. The method as claimed in at least one of claims 1 to 4, wherein the plurality of cells (100) comprises at least one center cell (100_CC) disposed in a central region of the battery module (30) and an end cell (100_EC) disposed in an end region of the battery module (30), and
the determining the thickness of the outer wall of the cell test apparatus (1200) comprises:
obtaining a first stress value of the end cell (1210), and
obtaining a second stress value of the at least one center cell (1220),
wherein a target stress value of the one or more target cells (100) is determined to be a median between the first stress value and the second stress value (1230), and the thickness of the outer wall is determined based on the target stress value.

7. The method as claimed in at least one of the preceding claims, wherein determining the length of the spacer (1300) comprises:
obtaining a distance between two adjacent cells (100) in the battery module (30); and
determining the length of the spacer (410, 420) based on each of the obtained distance and the determined thickness of the thermal-insulation layer (220).

8. The method as claimed in at least one of the preceding claims, further comprising:
forming an insulation layer (250) in contact with a first long-side wall portion (150) of a cell (2100);
forming a first thermal-insulation layer (210) in contact with the insulation layer (2200);
forming a second thermal-insulation layer (220) in contact with a second long-side wall portion (150) that is arranged to be opposite to the first long-side wall portion (150) of the cell (2200);
forming a first outer wall (310) disposed at an outer side of the first thermal-insulation layer (2300);
forming a second outer wall (320) disposed at an outer side of the second thermal-insulation layer (2300);
forming a first spacer (410) disposed on a first short-side wall portion (140) of the cell (100) and connecting the first outer wall (310) and the second outer wall (2400); and
forming a second spacer (420) disposed on a second short-side wall portion (140) that is arranged to be opposite to the first short-side wall portion (140) of the cell (100) and connecting the first outer wall (310) and the second outer wall (2400).

9. The method as claimed in claim 8, further comprising:
analyzing thermal and structural properties of a battery module comprising a plurality of cells (100) including the cell (100) before the forming the first thermal-insulation layer (1000).

10. The method as claimed in claim 9, wherein analyzing the thermal and structural properties of the battery module comprises:
obtaining a temperature of the plurality of cells (100) of the battery module (1110); and
determining a thickness for each of the first thermal-insulation layer (210) and the second thermal-insulation layer (220) based on the obtained temperature (1130).

11. The method as claimed in claim 9, wherein the battery module (30) includes at least one center cell (100_CC) disposed in a central region of the battery module (30) and an end cell (100_EC) disposed in an end region of the battery module (30), and
the analyzing the thermal and structural properties of the battery module (1100) comprises:
obtaining a first stress value of the end cell (1110); and
obtaining a second stress value of the at least one center cell (1120); and
determining a thickness of each of the first outer wall (310) and the second outer wall (320) based on the first stress value and the second stress value (1130).

12. The method as claimed in claim 9, wherein analyzing the thermal and structural properties of the battery module comprises:
obtaining a distance between two adjacent cells (100) in the battery module; and
determining a length of each of the first spacer (410) and the second spacer (420), the thickness of the first thermal-insulation layer (210), and the thickness of the second thermal-insulation layer (220) based on the obtained distance.

13. The method as claimed in claim 8, further comprising forming an insulation layer (250) disposed between the first long-side wall portion (150) and the first thermal-insulation layer (210).

14. The method as claimed in claim 8, further comprising forming a cooling unit (500) disposed at a lower portion of the cell test apparatus (20).

15. A cell test apparatus, comprising:
a first thermal-insulation layer (210) disposed on a first long-side wall portion (150) of a cell (100);
an insulation layer (250) disposed between the first long-side wall portion (150) and the first thermal-insulation layer (210) of the cell (100);
a second thermal-insulation layer (220) in contact with a second long-side wall portion (150) that is arranged to be opposite to the first long-side wall portion (150) of the cell (100);
a first outer wall (310) disposed at an outer side of the first thermal-insulation layer (210);
a second outer wall (320) disposed at an outer side of the second thermal-insulation layer (220);
a first spacer (410) disposed on a first short-side wall portion (140) of the cell (100) and connecting the first outer wall (310) and the second outer wall (320); and
a second spacer (420) disposed on a second short-side wall portion (140) that is arranged to be opposite to the first short-side wall portion (140) of the cell (100) and connecting the first outer wall (310) and the second outer wall (320); and
a cooling unit (500) disposed at a lower portion of the cell (100).
